Europäisches Patentamt

European Patent Office

Office européen des brevets

(11) Publication number: **0 283 593**
**A1**

## EUROPEAN PATENT APPLICATION

(21) Application number: 87200538.4

(22) Date of filing: 25.03.87

(51) Int. Cl.⁴ **H04N 5/14** , H03F 3/45

(43) Date of publication of application:
28.09.88 Bulletin 88/39

(84) Designated Contracting States:
AT BE CH DE ES FR GB GR IT LI LU NL SE

(71) Applicant: Océ-Nederland B.V.
St. Urbanusweg 43
NL-5914 CC Venlo(NL)

(72) Inventor: Simons, Johannes Mathieu Marie
Molenbossen 422
NL-5923 AG Venlo(NL)
Inventor: Michels, Casper Paul Mathilde
Harpstraat 2
NL-5802 KM Venray(NL)

(74) Representative: Hanneman, Henri W.A.M.
Océ-Nederland B.V. Patents and Information
Postbus 101
NL-5900 MA Venlo(NL)

(54) Videoamplifier.

(57) A videoamplifier including at least one transistor amplifying circuit ($T_1$, $T_2$, 10, 18, 20) which is designed in such a way that the transistors ($T_1$, $T_2$) will exhibit a linear characteristic in a range of small variations of the input signal ($V_i$) and a hard switching characteristic in response to large input signal variations. Due to this circuit design, the output signal ($V_o$) will, in general, be proportional to the input signal ($V_i$) but will be able to respond more quickly to a sudden increase of the input signal.

*Fig. 1*

## Videoamplifier

The present invention relates to a broadband amplifier such as a videoamplifier.

If the output signal of the amplifier is treated as a binary signal, the amplifier may have a hard switching characteristic. On the other hand, if it is required that the output signal should have a plurality of different values corresponding to different picture half-tones, videoamplifiers with a linear characteristic have been used. However, the large signal behaviour of conventional linear amplifiers has proved not to be satisfactory in certain applications. In particular, if a sudden stepwise rise occurs in the input signal, it is observed that the output signal cannot keep up with the rise of the input signal, because the output voltage of such a videoamplifier is only increased with a limited slew rate. Thus, the output signal will reach the desired voltage level only after a certain rise time. If the signal that has to be amplified is a pulse signal which has a pulse width in the order of or even smaller than said rise time, the output signal will not be able to reach its full amplitude. Consequently, the band-width of the amplifier is practically limited by the rise time.

It is therefore an object of the present invention to provide a videoamplifier which has an increased band-width and is capable of reproducing variations in the output level over a wide range of amplitudes, even when the pulse width of the input signal is small.

This object is achieved by a videoamplifier having the features as described in claim 1.

According to the invention, in a one-stage or multi-stage videoamplifier, at least one transistor amplifying circuit is designed in such a way that the transistors exhibit a linear characteristic in a range of small variations of the input signal and a hard switching characteristic in the range of large input signal variations. Due to the hard switching characteristics of the transistors, the slew rate of the amplifier is increased and the rise time of the output signal in response to a large stepwise rise of the input signal is reduced. On the other hand, when the variation of the input signal is small or when the input signal is substantially constant after a large stepwise rise, the linear characteristic is predominant so that the output signal is kept at the desired level proportional to the input level.

Due to this behaviour, a videoamplifier according to the invention is capable of amplifying for instance a pulse-like video signal the amplitude of which varies between sixteen distinct values corresponding to sixteen picture half-tones. Even if the frequency of the input signal is as large as for instance 150 to 200 MHz, the maximal rise time of the output signal will be smaller than the pulse width so that all sixteen output levels will be fairly distinguishable from each other.

A useful amplifying circuit which provides the desired amplifying characteristic is specified in claim 2.

The subclaims relate to more specific features of the amplifying circuit which lead to a simple low-cost circuit construction and to a reduction of energy dissipation.

Preferred embodiments of the invention will be described hereinbelow in conjunction with the accompanying drawings in which:

Fig. 1 is a circuit diagram illustrating the concept of an amplifying circuit according to a first embodiment of the invention;

Fig. 2 shows a modified example of the circuit according to the first embodiment;

Fig. 3 is a diagram illustrating a second embodiment of the invention;

Fig. 4 shows a modified example of the embodiment according to Fig. 3, and

Fig. 5 shows another modification of the embodiment according to Fig. 3.

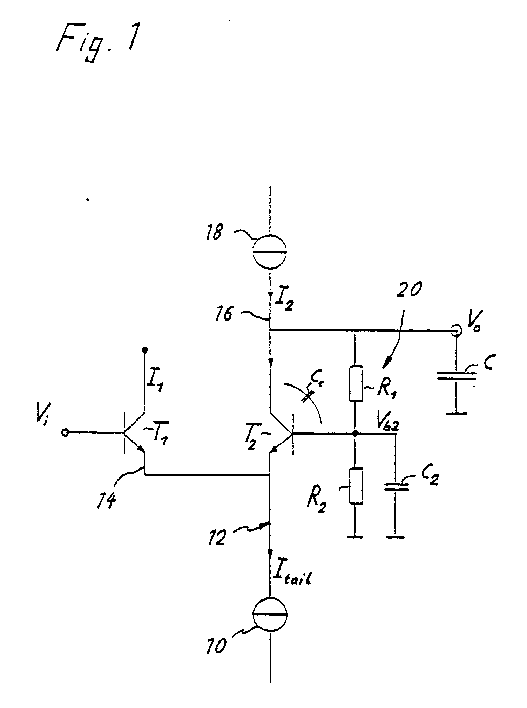

Referring to Fig. 1, an amplifying circuit includes a constant current source 10 connected to a branched circuit 12 which has first and second parallel branches 14, 16 connected in series to the current source 10. The first branch 14 includes a transistor $T_1$ which has its collector connected to a positive voltage terminal ( + ). The input voltage $V_i$ of the amplifying circuit is supplied to the base of the transistor $T_1$.

The second branch 16 includes a transistor $T_2$, the collector of which is connected to another constant current source 18. The output voltage $V_o$ is picked up at a point between the current source 18 and the transistor $T_2$. A capacitive load applied to the output of the amplifying circuit is represented by a capacitor C. A feedback circuit 20 for controlling the base voltage $V_{b2}$ of the transistor $T_2$ comprises a resistor $R_1$ connected between the collector and the base of the transistor $T_2$ and a resistor $R_2$ and a capacitor $C_2$ connected in parallel between the base of the transistor $T_2$ and ground.

The transistors $T_1$ and $T_2$ are of the same type, and the current $I_2$ flowing through the current source 18 is one half of the current $I_{tail}$ flowing through the current source 10. Consequently, the current $I_1$ flowing through the transistor $T_1$ is equal to $I_2$, and the voltage $V_{b2}$ is normally equal to $V_i$.

In response to small or slow variations of the input voltage $V_i$, the voltage $V_{b2}$ changes in accordance with $V_i$. If, for instance, the input voltage $V_i$ is increased, the base-emitter voltage drop across

the transistor $T_2$ is reduced so that the emitter voltages $V_e$ of both transistors $T_1$, $T_2$ become larger. As the base-emitter voltage of the transistor $T_2$ tends to be reduced, the voltage drop across the transistor $T_2$ and consequently the output voltage $V_o$ is increased. The base voltage $V_{b2}$ of the transistor $T_2$ is increased due to the effect of the voltage dividing resistors $R_1$, $R_2$. Thus, a new equilibrium is reached as soon as $V_{b2}$ equals the new level of the input voltage $V_i$. The amplification factor A is given by

$$A = V_o/V_i = V_o/V_{b2} = 1 + R_1/R_2$$

In the event of a large sudden increase of the input voltage $V_i$, the feedback circuit 20 increases the base voltage $V_{b2}$ of the transistor $T_2$ only with a certain delay which in the present example is determined by the capacity of the capacitors C and $C_2$. In this case, the transitors $T_1$ and $T_2$ behave like switches. The transitor $T_1$ is fully opened while the transistor $T_2$ is fully closed. Consequently, the complete current $I_2$ is available for charging the load capacitor C. This results in a superproportional increase of the output voltage $V_o$.

In the case of hard switching behaviour of the transistors $T_1$, $T_2$, the slew rate, i.e. the maximal rate of increase of the output voltage $V_o$ is given by

$$V_o = I_2/C_{tot}$$

wherein $C_{tot}$ is the total output capacity. Considering a sinusoidal output signal with the amplitude $V_{max}$, the band-width (indicated by f(-3dB)) is given by

$$(V_{max}/\sqrt{2}) . 2\pi. \ f(-3dB) = I_2/C_{tot} = (1/2)I_{tail}/C_{tot}f(-3dB) = (1/2)I_{tail}.\sqrt{2}/(2\pi C_{tot}V_{max}).$$

If, for instance, the maximum output amplitude $V_{max}$ is 10V and the output capacity is 8pF, and if $I_{tail}$ is set to 108mA, the band-width f(-3dB) is as large as 150MHz.

The capacity of $C_2$ should be adjusted so as to optimize the small signal behaviour. Considering a straight frequency curve, $C_2$ should be in the order of

$$(C + C_c).2.re.A.(1/R_1 + 1/R_2) + C_c.R_1/R_2$$

wherein $C_c$ is the collector-base capacity and re is the emitter impedance ($U_{BE}/I_C$) of the transistor $T_2$ and A is the amplification factor.

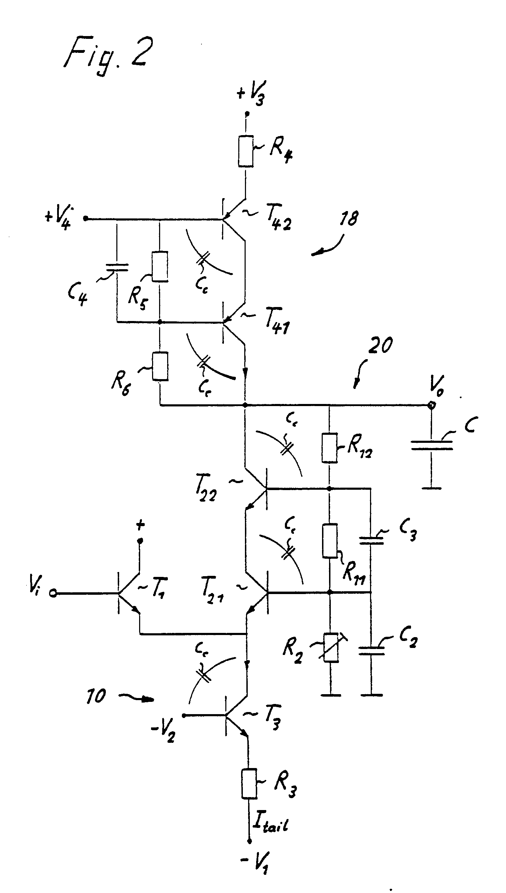

Fig. 2 shows a modified amplifier circuit wherein the transistor $T_2$ has been replaced by a series connection of two transistors $T_{21}$, $T_{22}$. The resistor $R_1$ has been replaced by a series connection of two resistors $R_{11}$, $R_{12}$. The base of the transistor $T_{22}$ is connected to a point between the resistors $R_{11}$ and $R_{12}$. A capacitor $C_3$ for compensating the influence of the collector-base capacity $C_c$ of the transistor $T_{21}$ is connected in parallel to resistor $R_{11}$ and has a capacity value substantially equal to $C_c$.

The current source 10 is formed by a transistor $T_3$ and an emitter resistor $R_3$ which is connected to a negative voltage terminal $-V_1$. The base of the transistor $T_3$ is connected to another negative voltage terminal $-V_2$.

The current source 18 is formed by a series connection of two transistors $T_{41}$, $T_{42}$ and an emitter resistor $R_4$ connected to a positive voltage terminal $+V_3$. The base of transistor $T_{42}$ is connected to a positive voltage terminal $+V_4$. The base of the transistor $T_{41}$ is connected to the voltage terminal $+V_4$ and to the output terminal $V_o$ via resistors $R_5$ and $R_6$ respectively. A capacitor $C_4$ is connected in parallel with the resistor $R_5$ and has a capacity value substantially equal to the capacity $C_c$ of the transistor $T_{42}$.

The purpose of providing series of transistors $T_{21}$, $T_{22}$ and $T_{41}$, $T_{42}$ instead of single transistors is to reduce the power dissipation and the collector-emitter tension of each transistor.

The transistors $T_1$, $T_{21}$, and $T_3$ are npn-transistors of the same type. They have a very small collector-base capacity (e.g. $C_c$ = 2pF) and a limit frequency of 2GHz. The emitter current gain $\alpha'$ - ($h_{FE}$) is about 50. The transistors $T_{41}$ and $T_{42}$ are pnp-transistors, that also have a small collector-base capacity substantially equal to that of the transistors $T_{21}$, $T_{22}$.

In this embodiment, the voltage $-V_1$ is in the order of -5V while the voltage $+V_3$ is about 35V. The resistance of the resistors $R_{11}$, $R_{12}$, $R_5$ and $R_6$ is about 1kΩ and the resistance of $R_2$ is about 100Ω. If the input voltage $V_i$ varies in a range of 0,1 to 1,1V, the output voltage $V_o$ is in the range of approximately 5 to 25V. The current $I_{tail}$ is about 80mA and the output capacity C is about 4pF. The capacity $C_2$ is approximately 50pF.

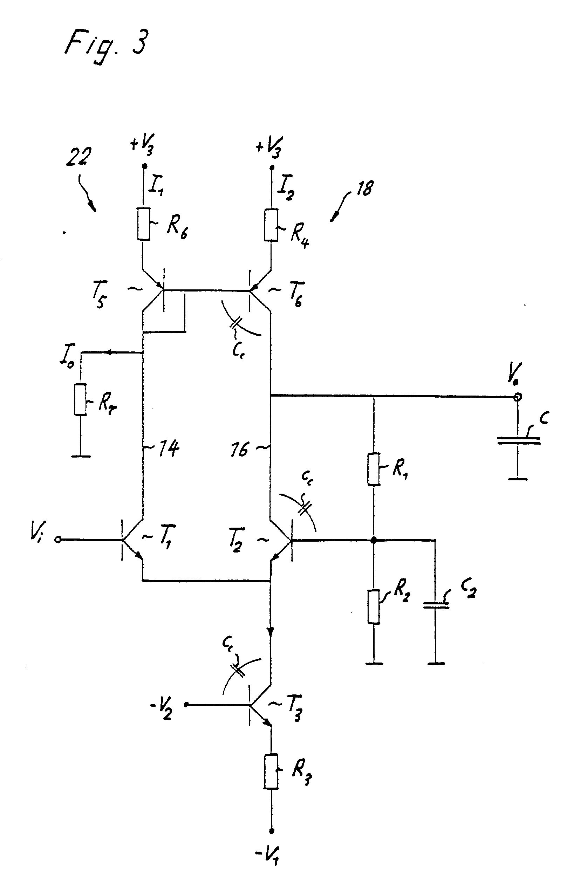

A different embodiment of the invention is illustrated in Fig. 3. This embodiment is different from the previously described embodiment in that the collector of the transistor $T_1$ is connected to another current source 22 formed by a pnp-transistor $T_5$ and an emitter resistor $R_6$ connected to the positive voltage terminal $+V_3$. The collector of the transistor $T_5$ is directly connected to the base of this transistor and is further connected to ground via a resistor $R_7$ which has a comparatively high resistance or even can be omitted.

The current source 18 is formed by a single transistor $T_6$ the base of which is directly coupled to the base of the transistor $T_5$.

If the transistor $T_1$ opens, the base voltage of the transistor $T_5$ drops so that the current $I_1$ delivered by the current source 22 increases. As the current sources 18 and 22 are interlocked with each other due to the common potential of the bases of the transistors $T_6$ and $T_5$, the increase of the current $I_1$ is reflected by a like increase of the current $I_2$. Thus, if the transistor $T_1$ is fully open and the transistor $T_2$ is fully closed, $I_2$ becomes equal to

$I_{tail}$. Consequently, the slew rate is twice as high as in the first embodiment.

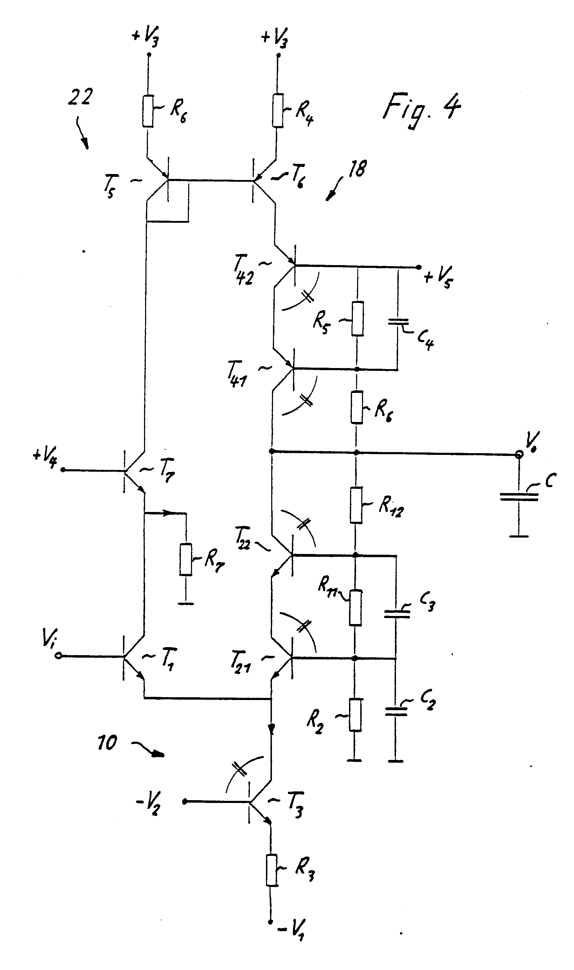

In a modified circuit shown in Fig. 4, the single transistor $T_2$, is again replaced by a series of transistors. The current source 22 includes a transistor $T_7$ interposed between the collector of the transistor $T_5$ and the connecting point of the resistor $R_7$. The base of the transistor $T_7$ is connected to a constant voltage terminal $+V_4$.

The current source 18 comprises the transistor $T_6$ described in conjunction with Fig. 3 and transistors $T_{41}$ and $T_{42}$ which may be compared to the transistors $T_{41}$ and $T_{42}$ in Fig. 2. The base of the transistor $T_{42}$ is connected to a positive voltage terminal $+V_5$ the voltage of which is smaller than $V_3$ but larger than $V_4$.

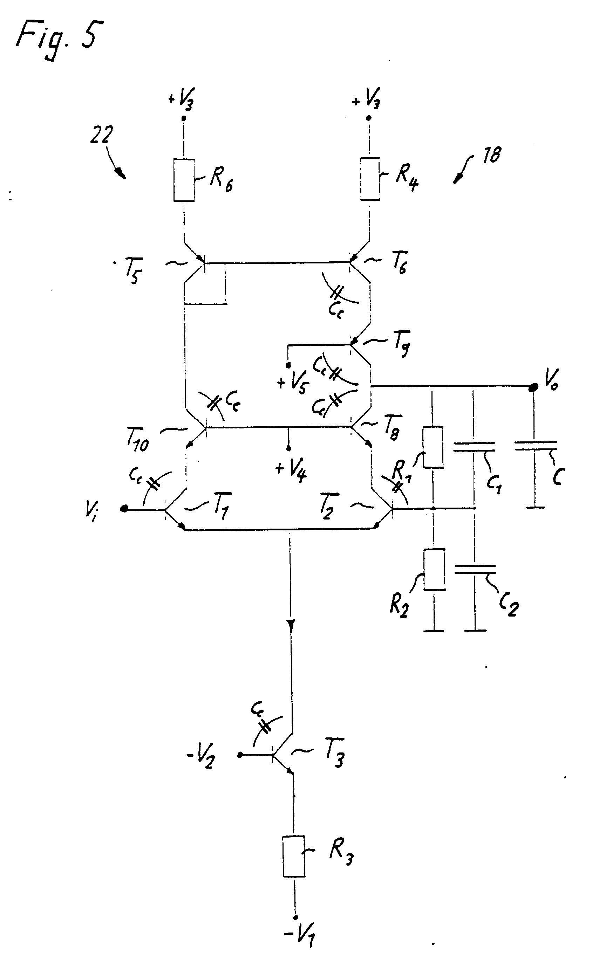

A preferred mode of realizing the invention will now be described in conjunction with Fig. 5 which shows another modification of the circuit according to Fig. 3.

According to Fig. 5, additional transistors $T_8$ and $T_9$ are connected in series between the transistors $T_2$ and $T_6$. Another additional transistor $T_{10}$ is interposed between the transistors $T_1$ and $T_5$. The bases of the transistors $T_8$ and $T_{10}$ are connected to a constant voltage terminal $+V_4$, and the base of the transistor $T_9$ is connected to another constant voltage terminal $+V_5$.

A capacitor $C_1$ is connected in parallel with the resistor $R_1$.

The resistor $R_7$ (Fig. 3) is removed.

In the example shown in Fig. 5, the voltage $-V_1$ has a value of about -5V, while the voltage $+V_3$ has a value of about +42V. The voltages at the terminals $+V_4$ and $+V_5$ are selected in such a manner that the transistors $T_8$, $T_9$ and $T_{10}$ are not saturated. For example, the voltage at the terminal $+V_4$ is set to +4V, and the voltage at the terminal $+V_5$ is set to +38V. Accordingly, the voltage drop across the transistors $T_1$, $T_2$ and across the transistors $T_5$, $T_6$ is comparatively small.

In general, the collector-base capacitance of a transistor is dependent on the collector-base voltage $V_{CB}$. The circuit according to Fig. 5 has the advantage that the collector-base capacitance $C_c$ of the transistors $T_1$, $T_2$ and $T_6$ is almost constant, so that the influence of changes of the input and output voltages on the collector-base capacitance and hence on the frequency curve of the amplifier is eliminated. Specifically, when the output voltage $V_o$ changes, the collector-base capacitance $C_c$ of the transistor $T_2$ and, consequently, the input capacitance $C_{in}$ of this transistor is almost constant. The sum of the collector-base capacitances $C_c$ of the transistors $T_8$ and $T_9$ is constant as well. Thus, the frequency curve of the amplifying circuit is fixed by the constant values of $R_1$, $C_1$, $R_2$, $C_2$ and $C_{in}$.

The capacitor $C_1$ is provided in order to make the proper selection of the capacitor $C_2$ less critical. The value of the capacitance $C_1$ should be chosen as low as possible and practical. A straight frequency curve is obtained if

$$C_2 + C_{in} \cong C_1 \cdot R_1/R_2$$

In a practical example, C has a value of 4pF, $C_c$ has a value of 1 to 2pF, and $C_1$ is set to 1pF, while $C_2$ is set to about 6 to 12pF.

The total output capacitance $C_{tot}$ is given by

$$C_{tot} = C + 2C_c + \cfrac{1}{1/C_1 + 1/C_2}$$

The transistors $T_9$ and $T_{10}$ prevent large changes of the collector-base voltages of the transistors $T_6$ and $T_1$, respecively, so that the collector-base capacitances $C_c$ of the transistors $T_6$ and $T_1$ are also substantially constant.

Further, the transistors $T_8$, $T_9$ and $T_{10}$ dissipate the largest part of the power, so that the transistors $T_1$, $T_2$, $T_5$ and $T_6$ have only low power dissipations (e.g. smaller than 1 watt). This has the advantage that the temperature offset of these transistors is reduced.

The invention is not limited to the examples described above. It will occur to a person skilled in the art that the described examples may be modified in various ways without departing from the spirit of the invention. Such modifications are considered to be within the scope of the invention which is defined in the claims.

## Claims

1. A videoamplifier including at least one transistor amplifying circuit ($T_1$, $T_2$, 10, 18, 20), **characterized** in that said amplifying circuit is designed is such a way that the transistors ($T_1$, $T_2$) exhibit a linear characteristic in a range of small variations of the input signal ($V_i$) and a hard switching characteristic in response to large input signal variations.

2. An amplyfying circuit **characterized** by
- a first current source (10) connected to a branched circuit (12),
- first transistor means ($T_1$) provided in a first branch (14) of said branched circuit, said first transistor means being responsive to the input voltage ($V_i$) to control a current ($I_1$) flowing in said first branch (14),
- a second current source (18) provided in a second branch (16) of said branched circuit,
- second transistors means ($T_2$; $T_{21}$, $T_{22}$) provided in

said second branch (16) between said first and second current sources (10, 18) and
- a feedback circuit (20) for deriving from the output voltage ($V_o$) picked-up between the second current source (18) and the second transistor means a control signal ($V_{b2}$) for the second transistor means.

3. An amplifying circuit as claimed in claim 2, wherein said feedback circuit (20) comprises a first resistor ($R_1$, $R_{11}$, $R_{12}$) connected between the collector and the base of said second transistor means, a second resistor ($R_2$) connected between the base of said second transistor means and ground and a capacitor ($C_2$) connected in parallel to said second resistor ($R_2$).

4. An amplifying circuit as claimed in claim 2 or 3, wherein the current ($I_1$) flowing in said first branch (14) is delivered by a third current source (22) and wherein said second current source (18) is interlocked with said third current source (22) such that a change of the current ($I_1$) in said first branch (14) is reflected by a like change of the current ($I_2$) delivered by said second current source (18).

5. An amplifying circuit as claimed in any of the claims 2 to 4, wherein said second transistor means ($T_{21}$, $T_{22}$) and/or said second and third current sources (18, 22) each include at least two transistors ($T_{21}$, $T_{22}$; $T_{41}$, $T_{42}$, $T_6$; $T_5$, $T_7$) connected in series.

6. An amplifying circuit as claimed in any of the claims 2 to 4, wherein said second branch (16) comprises first and second additional transistors ($T_8$, $T_9$) that are connected in series between said second transistor means ($T_2$) and said second current source (18), the output voltage ($V_o$) being picked-up at a point between said additional transistors, and wherein the bases of the additional transistors are respectively connected to constant voltage terminals ($+V_4$, $+V_5$) the voltages of which are selected in such a manner that the additional transistors are not saturated and the voltage drop across each of said additional transistors is larger than the voltage drop across said second transistor means ($T_2$) and than the voltage drop across an output transistor ($T_6$) of said second current source.

7. An amplifying circuit as claimed in claims 4 and 6, wherein said feedback circuit (20) comprises another capacitor ($C_1$) connected in parallel to said first resistor ($R_1$).

8. An amplifying circuit as claimed in claim 6 or 7, wherein a third additional transistor $T_{10}$ is interposed between said first current source (10) and said first transistor means ($T_1$) and has its base connected to the same voltage terminal ($+V_4$) as the first additional transistor ($T_8$) that is connected directly to the second transistor means ($T_2$).

Fig. 1

Fig. 2

Fig. 3

0 283 593

Océ 4/5

Fig. 4

# Fig. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 414 574  (VERLINDEN)<br>* column 1, line 47 -  column  2, line 47; figures 1, 2 * | 1,2 | H 04 N    5/14<br>H 03 F    3/45 |
| | --- | | |
| A | US-A-3 689 848  (GEFFE et al.)<br>* column  1, line 54 - column 2, line 21; figure 1 * | 1,2 | |
| | ----- | | |

|  |  |
|---|---|
| | TECHNICAL FIELDS SEARCHED (Int. Cl.4) |
| | H 04 N    5/00<br>H 03 F    3/00 |

The present search report has been drawn up for all claims

| Place of search | Date of completion of the search | Examiner |
|---|---|---|
| BERLIN | 04-11-1987 | DUDLEY C. |